# EUROPEAN PATENT SPECIFICATION

(11) **EP 3 259 778 B1**
(45) Date of publication and mention of the grant of the patent: **29.03.2023**
(21) Application number: 16752859.5
(22) Date of filing: 15.02.2016
(51) Int. Cl.: H01L 23/13, H01L 23/498, H01L 25/07, H01L 23/48, H01L 21/48

(54) **MICROELECTRONIC INTERCONNECT ADAPTOR**
ADAPTER FÜR MIKROELEKTRONISCHE VERBINDUNG
ADAPTATEUR D'INTERCONNEXION MICROÉLECTRONIQUE

(30) Priority: 17.02.2015 US 201514623687
(43) Date of publication of application: 27.12.2017
(73) Proprietor: Intel Corporation, Santa Clara, CA 95054 (US)
(72) Inventor: GEISSLER, Christian, 93356 Teugn (DE); REINGRUBER, Klaus, 84085 Langquaid (DE); ALBERS, Sven, 93049 Regensburg (DE)
(74) Representative: Rummler, Felix
(86) International application number: PCT/US2016/017935
(87) International publication number: WO 2016/133836

(56) References cited:
- EP-A2- 0 898 311
- JP-A- H1 022 341
- JP-A- H07 221 433
- JP-A- H11 121 524
- KR-A- 20120 018 526
- KR-B1- 100 267 558
- US-A1- 2009 107 703
- US-A1- 2011 237 952
- US-A1- 2011 242 780
- US-A1- 2014 225 273
- US-B1- 6 258 625
- US-B1- 6 392 143
- US-B1- 7 310 239

## Description

### TECHNICAL FIELD

Embodiments of the present description generally relate to the field of microelectronic devices, and, more particularly, to microelectronic structures which include an microelectronic interconnect adaptor that allows the microelectronic structures to be attached to a variety of substrates.

### BACKGROUND

As microelectronic devices are becoming ever smaller, the ability to fabricate microelectronic devices into wearable microelectronic systems is becoming prevalent. Wearable microelectronics systems are expected to be common products for medical applications and for enabling the Internet of Things ("IoT" - equipping multiple objects with small identification devices, which may connect with the internet to network and communicate with each other).

For packaging such wearable devices, there will need to be, on one hand, increased integration density (such as System in Package (SiP)) and, on the other hand, increased dimensional reduction (e.g. length (x), width (y), and height (z) dimensions). Reducing the length and width is important in order to reduce the surface area required on a printed circuit board or module to which the microelectronic packages are mounted. Reducing the height is important not only for dimensional reduction, but also for bending/flexibility to assemble the packages on flexible printed circuit boards or on slightly bent printed circuit boards. This bending/flexibility can be achieved by using thin microelectronic packages with very thin microelectronic dice inside. These thin microelectronic packages may be mounted on a flexible printed circuit board, which may then be slightly bent to fit into a module or chase. However, common microelectronic packages, such as Fan-Out Wafer Level Packages (FO WLP), Wafer Level Chip-Scale Packages (WLCSP), or Flip Chip (FC) packages, even if extremely thinned 25 have only a very limited bending flexibility. Furthermore, packages and the microelectronic dice therein reduces the mechanical stability thereof.

Moreover, bending of microelectronic dice (such as silicon-based dice) may have negative impact on performance due to asymmetric mechanical stress on crystal structure thereof. Depending on bending direction, performance of integrated circuitry, such as transistors, formed in the microelectronic dice may be reduced, for example, by as much as about 20%. This may lead to significant non-uniformities of the performance of integrated circuitry within the bent microelectronic dice, which may require re-designing the integrated circuitry therein.

Yet further, for highly bent printed circuit boards, such as tube shaped surfaces, stepped surfaces, 90° z-direction angles, or for bridging purposes, bending the microelectronic packages is not suitable. Although, some of these issues may be addressed with printed electronics technologies, these organic based devices suffer from poor electrical performance.

Examples of microelectronic/semiconductor packages and integrated circuitry technologies are discussed in US 2011/242780, US 6258625, JP H07 221433, US 2014/225273, US 7310239, JP H10 22341, EP 0898311, and JP H11 121524.

US 2011/237952 discusses an ultrasonic probe comprising piezoelectric elements arranged in the form of a two-dimensional array.

Therefore, there is a need for microelectronic package designs which do not require bending when used in wearable microelectronic systems.

### SUMMARY OF THE INVENTION

According to the claimed invention, a microelectronic device is provided as defined in claim 1. The microelectronic device according to claim 1 has an arcuate surface (136₂) and a planar surface (134₂). The arcuate surface (136₂) is concave relative to the planar surface (134₂). Any other device described or drawn herein that does not include this feature, or corresponding process of its manufacture, is merely for information and is not part of the claimed invention.

### BRIEF DESCRIPTION OF THE DRAWINGS

FIG. 1 illustrates a cross-sectional view of a microelectronic package attached to an interconnect adaptor having a substantially planar surface and a non planar surface with interconnects extending from the planar surface to the non-planar surface, according to an example not falling within the scope of the claims.
FIG. 2 illustrate a cross-sectional view of a configuration of an interconnect adaptor attached to a microelectronic substrate, according to an embodiment of the claimed invention.
FIGs. 3-6 illustrate cross-sectional views of various configurations of interconnect adaptors attached to microelectronic substrates, according to examples not falling within the scope of the claims.
FIGs. 7-16 illustrate cross-sectional views of a process of fabricating the microelectronic component of FIG. 1, according to an example not falling within the scope of the claims.
FIG. 17 is a flow diagram of a process of fabricating a microelectronic component.
FIG. 18 illustrates a computing device in accordance with one implementation of the present description.

### DESCRIPTION OF EMBODIMENTS

Embodiments of the present description include an interconnect adaptor having a substantially planar surface, to which a microelectronic package is electrically attached, and a concave arcuate surface with at least one interconnect, as defined in the appended claims.

The interconnect adaptor concave surface may be shaped to substantially conform to a shape of a microelectronic substrate to which it may be attached, which eliminates the need to bend or otherwise adapt the microelectronic package to conform to the microelectronic substrate.

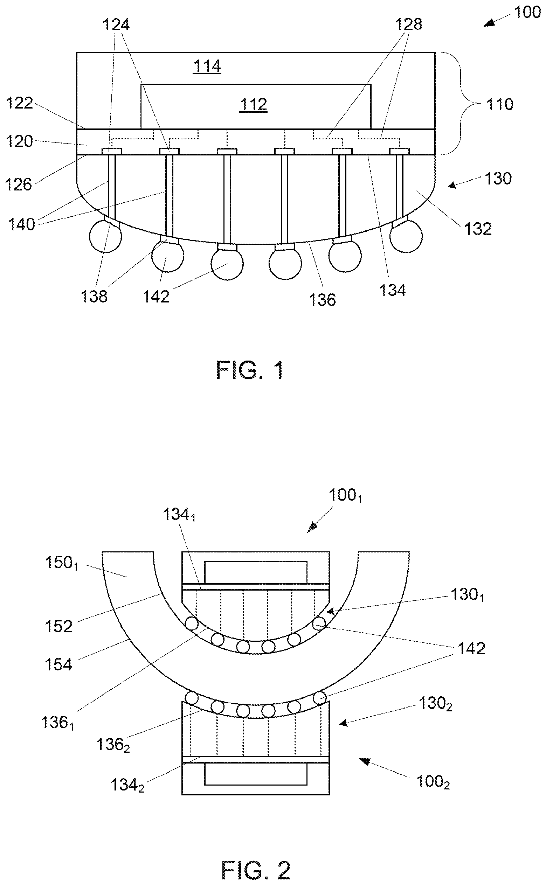

FIG. 1 illustrates a microelectronic component 100, according to one example not falling within the scope of the claims. As shown in FIG. 1, a microelectronic package 110 may be attached to an interconnect adaptor 130. The interconnect adaptor 130 may comprise an interconnect adaptor body 132 having a substantially planar surface 134, to which the microelectronic package 110 is electrically attached, and a non-planar surface 136 with at least one electronically conductive interconnect 140 extending from the interconnect adaptor body planar surface 134 to the interconnect adaptor body non-planar surface 136.

As shown in FIG. 1, the microelectronic package 110 may comprise a microelectronic device 112, such as a microprocessor, a chipset, a graphics device, a wireless device, a memory device, an application specific integrated circuit, or the like, electrically attached to a first surface 122 of an interposer or a build-up layer 120. An encapsulant material 114 may encapsulate the microelectronic device 112 and abut a portion of the interposer/build-up layer first surface 122. The interposer/build-up layer 120 may be electrically attached to the interconnects 140 at the interconnect adaptor body planar surface 134 with corresponding, mirror-image microelectronic package bond pads 124 formed at a second surface 126 of the interposer/build-up layer 120. The microelectronic package bond pads 124 may be electrically connected to integrated circuitry (not shown) within the microelectronic device 112 through conductive routes (shown as dashed lines 128) extending through the interposer/build-up layer 120.

Since the microelectronic package 110 is mounted to the interconnect adaptor planar surface 134, the microelectronic package 110 will stay planar and there is no need bend or otherwise distort the microelectronic package 110. Thus, as will be understood to those skilled in the art, although the microelectronic package 110 is illustrated in FIG. 1 as a Fan-Out Wafer Level Package (FO WLP), any appropriate packaging technologies can be used, as will be discussed.

The interconnect adaptor 130 may have at least one bond pad 138 formed at the interconnect adaptor body non-planar surface 136, wherein each bond pad 138 is in electrical contact with a corresponding interconnect 140. A connector 142, illustrated in FIG. 1 as a solder ball, may be formed on each of the interconnect adaptor bond pads 138.

The interconnect adaptor body 132 may be any appropriate, substantially rigid, dielectric material. The interconnects 140, the interconnect adaptor bond pads 138, and the microelectronic package bond pads 124 may be formed from any appropriate conducting material, including but not limited to metals and metal alloys, such as copper, silver, gold, nickel, and alloys thereof. The encapsulant material 114 may be any appropriate encapsulation material, including but not limited to, silica-filled epoxies and resins. The interposer/build-up layer 120 may be formed from multiple layers of dielectric material (not shown) including, but not limited to, silicon dioxide (SiO₂), silicon oxynitride (SiOₓN_{y}), and silicon nitride (Si₃N₄) and silicon carbide (SiC), liquid crystal polymer, epoxy resin, hismaleimide triazine resin, polyimide materials, and the like. The conductive routes 128 may be formed to extend between and through the dielectric material layers (not shown) and may be made of any appropriate conductive material, including, but not limited to, copper, silver, gold, nickel, and alloys thereof. The processes used for forming the microelectronic package 110 and components thereof are well known to those skilled in the art, and for the sake of brevity and conciseness will not be described or illustrated herein.

FIG. 2 illustrates an embodiment of microelectronic components 100 electrically connected to a microelectronic substrate 150 by the connectors 142. The microelectronic substrates 150 may comprise any appropriate dielectric material, including, but not limited to, liquid crystal polymer, epoxy resin, bismaleimide triazine resin, FR4, polyimide materials, and the like, and may include conductive routes (not shown) formed therein and/or thereon to form any desired electrical route within the microelectronic substrate 150, between the microelectronic components 100, and/or with additional external components (not shown). The processes used for forming the microelectronic substrate 150 are well known to those skilled in the art, and for the sake of brevity and conciseness will not be described or illustrated herein. As illustrated in FIGs. 2-6, the microelectronic substrates 150 may have a variety of shapes, wherein the interconnect adaptors 130 are configured to adjust to the shape of the microelectronic substrates 150.

As shown in FIG. 2, the microelectronic components 100₁, 100₂ have interconnect adaptors 130₁, 130₂, respectively, which include interconnect adaptor body non-planar surfaces 136₁, 136₂, respectively, that are curved or arcuate. In the upper microelectronic component 100₁, which is not part of the claimed invention, the interconnector adaptor body arcuate surface 136₁, is convex relative to the interconnect adaptor body planar surface 134₁, such that it may be attached to an interior surface 152 of a tube-shaped or a sphere-shaped microelectronic substrate 150.

In the lower microelectronic component 100₂ according to the claimed invention, the interconnect adaptor body arcuate surface 136₂, is concave relative to the interconnect adaptor body planar surface 134₂, such that it may be attached to an exterior surface 154 of a tube-shaped or a sphere-shaped microelectronic substrate 150₁.

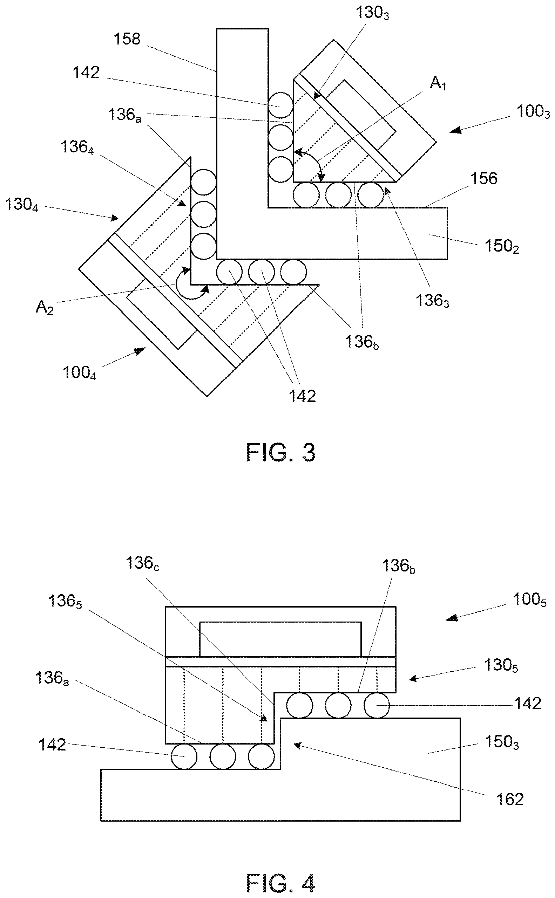

FIGs. 3-6 illustrates various examples not falling within the scope of the claims. As shown in FIG. 3, both microelectronic components 100₃,100₄, may have interconnect adaptors 130₃, 130₄, respectively, which include interconnect adaptor body non-planar surfaces 136₃, 136₄, respectively, that comprise two converging planar surfaces 136ₐ, 136_{b}. In the upper microelectronic component 100₃, the converging planar surfaces 136ₐ, 136_{b} may be angled at an acute angle A₁ to one another, such that they may be attached to an interior surface 156 of a substantially L-shaped microelectronic substrate 150₂. In the lower microelectronic component 100₄, the converging planar surfaces 136ₐ, 136_{b} may be angled at an obtuse angle A₂ to one another, such that they may be attached to an exterior surface 158 of the substantially L-shaped microelectronic substrate 150₂ .

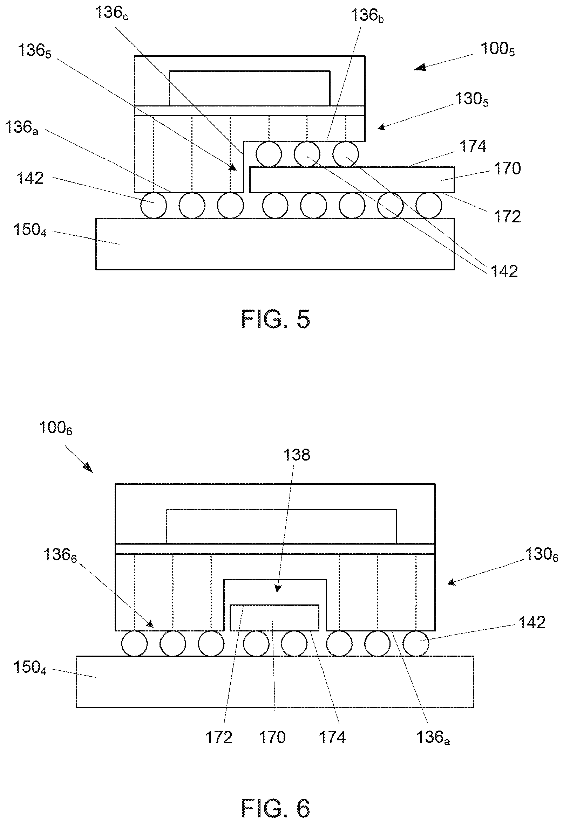

As shown in FIG. 4, the microelectronic component 100₅ may have an interconnect adaptor 130₅ which includes the interconnect adaptor body non-planar surfaces 136₅ that comprises two planar surfaces 136ₐ, 136_{b} that are parallel non-planar to one another (e.g. on differing parallel planes) and a connecting surface 136_{c} between two planar surfaces 136ₐ, 136_{b}. Such a configuration may allow for the electrical attachment of microelectronic component 100₅ to the microelectronic substrate 150₃, which has a stepped surface 162 substantially mirroring the interconnect adaptor body non-planar surface 136₅. As shown in FIG. 5, the microelectronic substrate 150₄ need not have a stepped surface 162 (see F1G.4) for the non-planar surface 136₅ shown in FIG. 4 to be used. Rather, an active surface 172 of a secondary microelectronic device 170, either active or passive, may be electrically attached to a planar microelectronic substrate 150₄, wherein one planar surface 136ₐ of the interconnect adaptor 130₅ is electrically connected to the microelectronic substrate 150₄ and the other planar surface 136_{b} of the interconnect adaptor 130₅ is electrically connected to a back surface 174 of the secondary microelectronic device 170, such as with through-silicon vias (not shown).

As shown in FIG. 6, the microelectronic component 100₆ may have an interconnect adaptor 136₆ which includes the interconnect adaptor body non-planar surface 136₆ that comprises at least one planar surface 136ₐ and a recess 138 extending into the interconnect adaptor 130₆, such that the recess 138 can span over the secondary microelectronic device 170.

As it can be seen in FIG. 2, the embodiment of the present description may allow for the microelectronic component 100 to be attached to bent or non-planar substrates 150 without the need to bend/stress the microelectronic package 110 and microelectronic device 112 therein. The microelectronic component 100 may allow for attach merit, to the microelectronic substrate 150 in positions where currently no placement is possible, which may reduce the form factor (e.g. size) of the resulting system or module as a whole and allow for attachment inside of small tubes or wearable items like rings or bracelets. Further, the embodiment of the present description may not require any microelectronic package or microelectronic die thinning, which might lead to performance degradation due to mechanical stress, as will be understood to those skilled in the art. Thus, standard, high performance packaging technologies like Fan-Out Wafer Level Packages (FO WLP) (illustrated in FIGs. 1-6), Wafer Level Chip-Scale Packages (WLCSP), Flip Chip (FC) packages, Quad Flat No-leads (QFN) packages, Dual Flat No-leads (DFN) packages, and the like, having many features, such as System in Package (SiP), Packag on-Package (PoP), 3D-stacking, and the like, may be used.

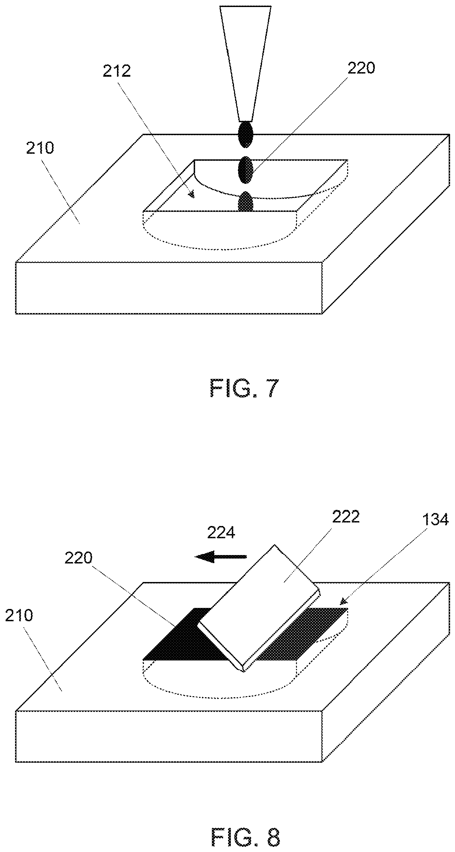

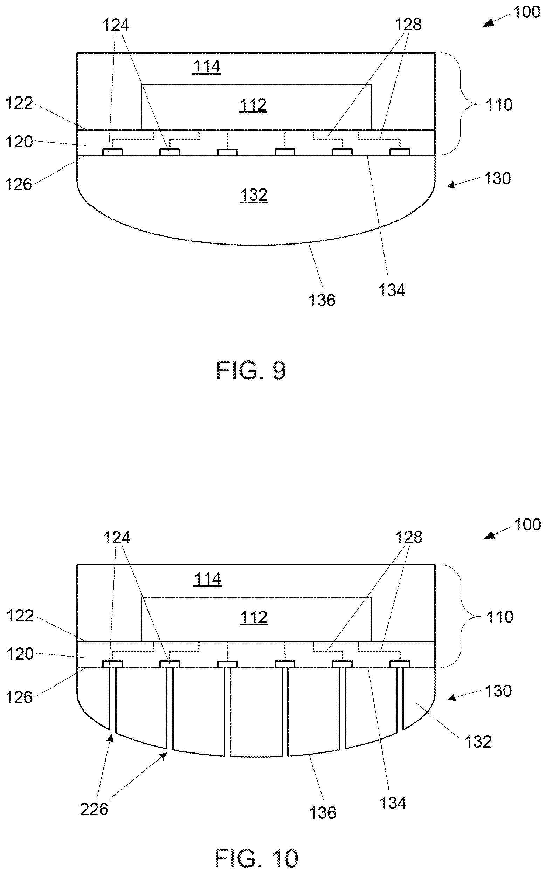

FIGs. 7-16 illustrate an example of fabricating the microelectronic component 100 illustrated in FIG. according to an example not falling within the scope of the claims. As shown in FIG. 7, a mold chase 210 may be formed having at least one recess 212 therein. As will be understood to those skilled in the art, the mold chase recess 212 may have a negative of the desired shape of the interconnect adaptor non-planar surface 136 (see FIG. 1). It is further understood by those skilled in the art that the configuration and number of mold chase recesses 212 may be determined by a package body technology used, such as panel, wafer, strip form, and the like. As further shown in FIG. 7, a liquid dielectric mold compound 220 may be deposited in and fill the mold chase recess 212. Once filled, excess dielectric mold compound 220 may be removed, such as by a removal tool or squeegee 222 drawn across (arrow' 224) the mold case 210, to form the interconnect adaptor planar surface 134, as shown in FIG. 8. As shown in FIG. 9, the dielectric mold compound 220 (see FIG. 8) may be cured or partially cured to form the interconnector adaptor body 132 of the interconnect adaptor 130 and the microelectronic package 110 may be attached to the interconnect adaptor body planar surface 134, which may occur before or after the removal of the dielectric mold compound 220 from the mold chase 210 (see FIGs. 7 and 8). Although a molding process is illustrated in FIGs. 7 and 8, it is understood that a bulk dielectric material could be mechanically polished, laser ablated, or the like to form the interconnector adaptor body 132, or the inter connector adaptor body 132 could be fabricated in 3-D printing process or the like.

After the formation of the interconnector adaptor body 132, as shown in FIG. 10, at least one via 226 may be formed to extend from the interconnect adaptor body non-planar surface 136 to the interconnect adaptor body planar surface 134, wherein a portion of each microelectronic package bond pad 124 may be exposed. The vias 226 may be formed by laser drilling. The use of laser drilling may result in no or very low taper to the vias 226 and may result in the vias 226 having diameters of between about 20µm and 25µm, which is independent of a distance between the interconnect adaptor body non-planar surface 136 to the interconnect adaptor body planar surface 134. If an electroless plating process is to be used to form the interconnects 140 (see FIG. 1), a seed layer (not shown) may be formed, such as by sputter deposition or electroless plating, on the exposed portions of each microelectronic package bond pad 124, the sidewalls of the vias 226, and the interconnect adaptor body non-planar surface 136.

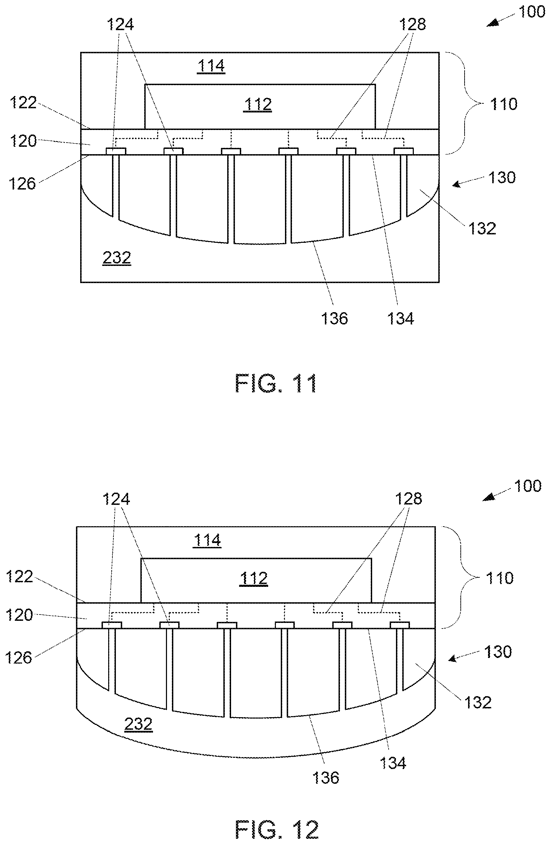

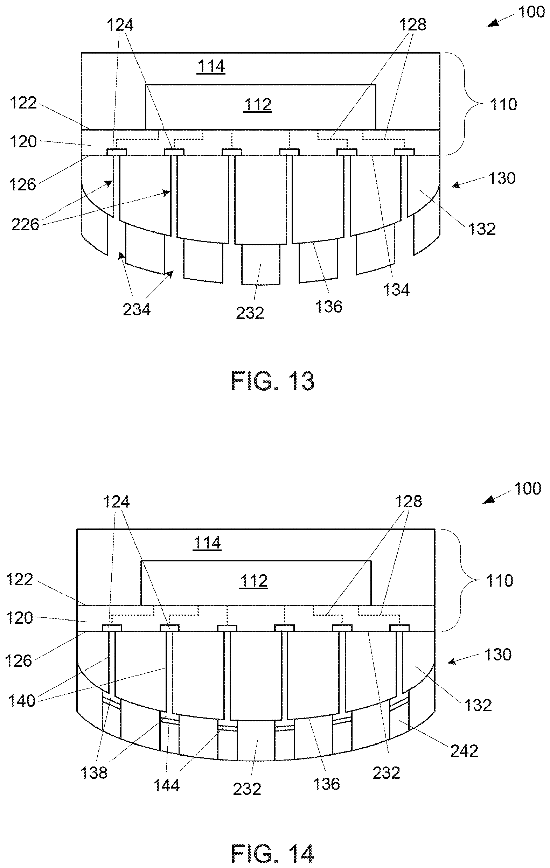

After forming the vias 226 (see FIG. 10), a resist material layer 232 may be formed over the interconnect adaptor body non-planar surface 136 either non-conformally, such as by spin-on coating, as shown in FIG. 11, or conformally, such as by spray coating, as shown in FIG. 12. The resist thickness may be between about 50µm and 100µm. As shown in FIG. 13, openings 234 may be formed through the resist material layer 232 to the vias 226 and the material within the vias 226 may be removed, such as by photolithography and/or laser drilling. A negative tone resist material layer 232 may be used to enable removal from the vias 226.

As shown in FIG. 14, the interconnects 140 may be formed within the vias 226 (see FIG. 13). The interconnects 140 may be formed by filling the vias 226 (see FIG. 13) with an electroless plating process (a seed layer (not shown) would be deposited after formation of the vias 226, as discussed with regard to FIG. 10). As shown in FIG. 14, the plating process may result in the formation of the interconnect adaptor bond pads 138 which are integral with their respective interconnect 140. The interconnects 140 may be formed from any appropriate metal. The interconnects 140 may be formed from, copper. For vias 226 (see FIG. 13) having diameters of between about 20µm and 25µm, the thickness of the plated material should be between about 15pm and 20pm to fill the vias 226 (see FIG. 13). As further shown in FIG. 14, after the formation of the interconnects 140 and interconnect adaptor bond pads 138, an underbump metallization structure 144, such, a nickel barrier layer and a tin/silver wetting layer, may be formed on each interconnect adaptor bond pad 138, As still further shown in FIG. 14, a solder material 242 may be deposited on each underbump metallization structure 144, The solder material 242 may be any appropriate material, including, but not limited to, lead/tin alloys, such as 63% tin / 37% lead solder, and high, tin content alloys (e.g. 90% or more tin), such as tin/bismuth, eutectic tin/silver, ternary tin/silver/copper, eutectic tin/copper, and similar alloys.

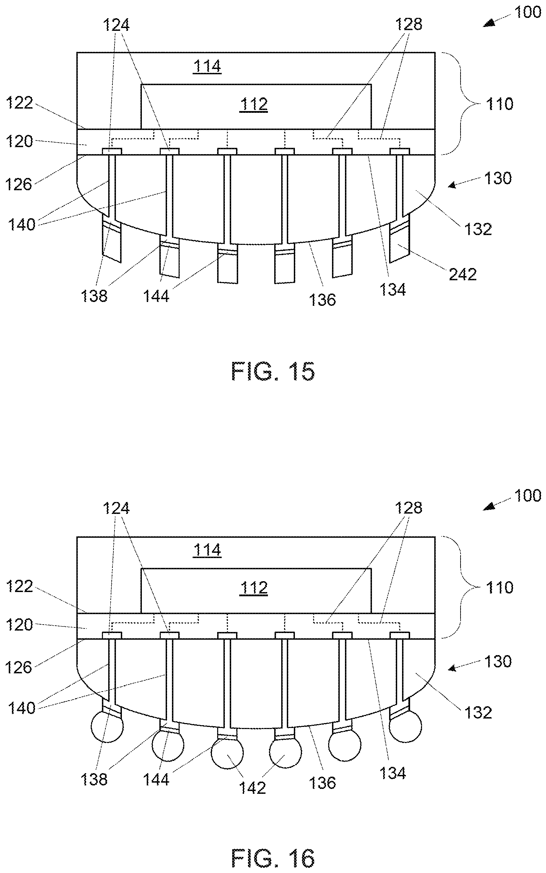

As shown in FIG, 15, the resist, material layer 232 (see FIG. 14) may be removed as well as any remaining seed layer material (not shown). As shown in FIG. 16, the solder material 242 (see FIG. 15) may be reflowed (heated) to from the connectors 142 (e.g. solder balls) and the resulting microelectronic component 100. It is understood that if a plurality of microelectronic components 100 were formed simultaneously and integrally, they would be singulated, such as by mechanical dicing, after the formation of the connectors 142.

It is understood that a similar process approach may be used to form differently shaped interconnect adaptor body non-planar surfaces 136, and it is further understood that process adaptations might be necessary.

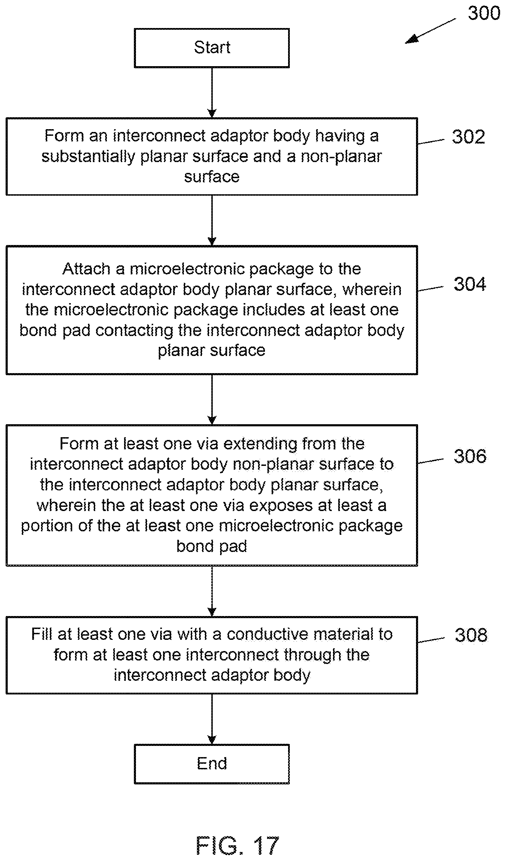

FIG. 17 is a flow chart of a process 300 of fabricating a flexible microelectronic system according to an embodiment of the present description. As set forth in block 302, an interconnect adaptor body having a substantially planar surface and a non-planar surface may be formed. A microelectronic package may be attached to the interconnect adaptor body planar surface, wherein the microelectronic package includes at least one bond pad contacting the interconnect adaptor body planar surface, as set forth in block 304. As set forth in block 306, at least one via may be formed extending from the interconnect adaptor body non-planar surface to the interconnect adaptor body planar surface, wherein the at least one via exposes at least a portion of at least, one microelectronic package bond pad. At least one via may be filled with a conductive material to form at least one interconnect through the interconnect adaptor body, as set forth in block 308.

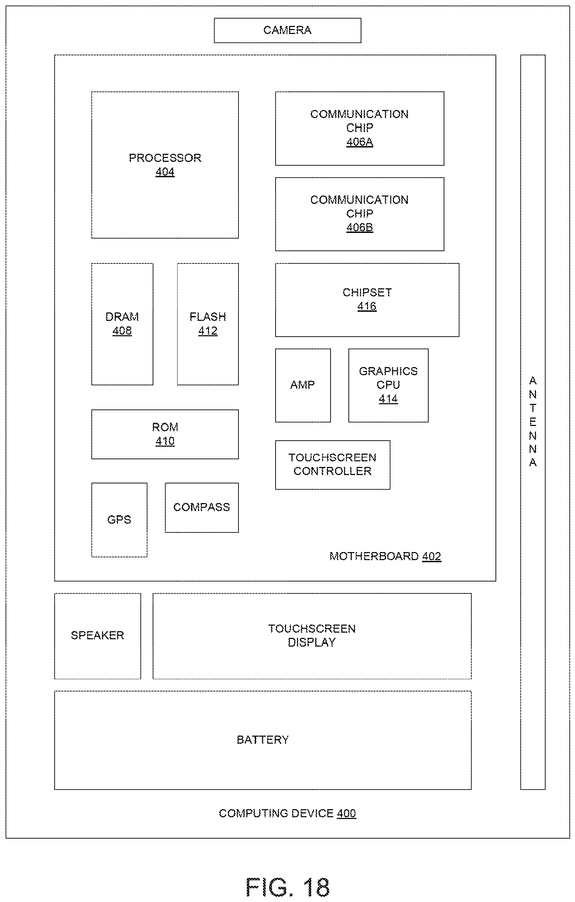

FIG. 18 illustrates a computing device 400 In accordance with one implementation of the present description. The computing device 400 houses a board 402. The board may include a number of microelectronic components, including but not limited to a processor 404, at least one communication chip 406A, 406B, volatile memory 408, (e.g., DRAM), non-volatile memory 410 (e.g., ROM), flash memory 412, a graphics processor or CPU 414, a digital signal processor (not shown), a crypto processor (not shown), a chipset 416, an antenna, a display (touchscreen display), a touchscreen controller, a battery, an audio codec (not shown), a video codec (not shown), a power amplifier (AMP), a global positioning system (GPS) device, a compass, an accelerometer (not shown), a gyroscope (not shown), a speaker (not shown), a camera, and a mass storage device (not shown) (such as hard disk drive, compact disk (CD), digital versatile disk (DVD), and so forth). Any of the microelectronic components may be physically and electrically coupled to the board 402. In some implementations, at least one of the microelectronic components may be a part of the processor 404.

The communication chip enables wireless communications for the transfer of data to and from the computing device. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA-h HSUPA+, EDGE, GSM, GPRS, CDMA, TDMA, DECT, Bluetooth, derivatives thereof, as well as any other wireless protocols that are designated as 3G, 4G, 5G, and beyond. The computing device may include a plurality of communication chips. For instance, a first communication chip may be dedicated to shorter range wireless communications such as Wi-Fi and Bluetooth and a second communication chip may be dedicated to longer range wireless communications such as GPS, EDGE, GPRS, CDMA, WiMAX, LTE, Ev-DO, and others.

The term "processor" may refer to any device or portion of a device that processes electronic data from registers and/or memory to transform that electronic data into other electronic data that may be stored in registers and/or memory.

Any of the microelectronic components within the computing device 400 may include a microelectronic structure having an interconnect adaptor as described above.

In various implementations, the computing device may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device may be any other electronic device that processes data.

## Claims

1. A microelectronic component (100₂) comprising an interconnect adaptor (130₂) having a substantially planar surface (134₂) and an arcuate surface (136₂) with at least one electrically conductive interconnect (140) extending from the planar surface (134₂) to the arcuate surface (136₂);
wherein the interconnect adapter (130₂) includes at least one bond pad (138) formed on the non-planar surface (136₂) that is attached to the at least one electrically conductive interconnect (140); and
wherein the microelectronic component (100₂) further comprises:
a microelectronic package (110) attached to the interconnect adaptor planar surface, wherein microelectronic package includes a bond pad (124) formed in the microelectronic package (110) and wherein at least one bond pad (124) of the microelectronic package contacts the at least one electronically conductive interconnect (140) of the interconnect adaptor (130₂); and
a microelectronic substrate (150) attached to the non-planar surface (136₂) with at least one solder ball (142) extending between the at least one bond pad (138) of the interconnector adaptor (130₂) and the microelectronic substrate (150);
**characterised in that**:
the arcuate surface (136₂) is concave relative to the planar surface (134₂).

2. The microelectronic component of claim 1, wherein the microelectronic package (110) comprises a microelectronic device (112) attached to an interposer (120).

3. The microelectronic component of claim 1, wherein the microelectronic package (110) comprises a microelectronic device (112) attached to a build-up layer (120).

## Patentansprüche

1. Mikroelektronisches Bauelement (100₂), umfassend einen Verbindungsadapter (130₂), der eine im Wesentlichen ebene Oberfläche (134₂) und eine bogenförmige Oberfläche (136₂) mit mindestens einer elektrisch leitenden Verbindung (140) aufweist, die sich von der ebenen Oberfläche (134₂) zu der bogenförmigen Oberfläche (136₂) erstreckt;
wobei der Verbindungsadapter (130₂) mindestens eine Bondkontaktstelle (138) enthält, die auf der nicht-ebenen Oberfläche (136₂) ausgebildet ist und an der mindestens einen elektrisch leitenden Verbindung (140) angebracht ist; und
wobei das mikroelektronische Bauelement (1002) ferner umfasst:
ein mikroelektronisches Gehäuse (110), das an der ebenen Oberfläche des Verbindungsadapters angebracht ist, wobei das mikroelektronische Gehäuse eine in dem mikroelektronischen Gehäuse (110) ausgebildete Bondkontaktstelle (124) enthält und wobei mindestens eine Bondkontaktstelle (124) des mikroelektronischen Gehäuses die mindestens eine elektronisch leitende Verbindung (140) des Verbindungsadapters (130₂) kontaktiert; und
ein mikroelektronisches Substrat (150), das an der nicht-ebenen Oberfläche (136₂) angebracht ist, wobei sich mindestens eine Lötkugel (142) zwischen der mindestens einen Bondkontaktstelle (138) des Verbindungsadapters (130₂) und dem mikroelektronischen Substrat (150) erstreckt; **dadurch gekennzeichnet, dass**:
die bogenförmige Oberfläche (136₂) relativ zur ebenen Oberfläche (134₂) konkav ist.

2. Mikroelektronisches Bauelement gemäß Anspruch 1, wobei das mikroelektronische Gehäuse (110) ein mikroelektronisches Bauelement (112) umfasst, das an einem Zwischenelement (120) angebracht ist.

3. Mikroelektronisches Bauelement gemäß Anspruch 1, wobei das mikroelektronische Gehäuse (110) eine mikroelektronische Vorrichtung (112) umfasst, die an einer Aufbauschicht (120) angebracht ist.

## Revendications

1. Composant microélectronique (100₂), comprenant un adaptateur d'interconnexion (130₂) ayant une surface sensiblement plane (134₂) et une surface arquée (136₂) avec au moins une interconnexion électriquement conductrice (140) s'étendant depuis la surface plane (134₂) jusqu'à la surface arquée (136₂) ;
dans lequel l'adaptateur d'interconnexion (130₂) inclut au moins un plot de connexion (138), formé sur la surface non plane (136₂), qui est attaché à l'au moins une interconnexion électriquement conductrice (140) ; et
dans lequel le composant microélectronique (100₂) comprend en outre :
un boîtier microélectronique (110) attaché à la surface plane d'adaptateur d'interconnexion, dans lequel le boîtier microélectronique inclut un plot de connexion (124) formé dans le boîtier microélectronique (110) et dans lequel au moins un plot de connexion (124) du boîtier microélectronique entre en contact avec l'au moins une interconnexion électroniquement conductrice (140) de l'adaptateur d'interconnexion (130₂) ; et
un substrat microélectronique (150) attaché à la surface non plane (136₂) avec au moins une bille de soudure (142) s'étendant entre l'au moins un plot de connexion (138) de l'adaptateur d'interconnexion (130₂) et le substrat microélectronique (150) ;
**caractérisé en ce que** :
la surface arquée (136₂) est concave relativement à la surface plane (134₂).

2. Composant microélectronique selon la revendication 1, dans lequel le boîtier microélectronique (110) comprend un dispositif microélectronique (112) attaché à un interposeur (120).

3. Composant microélectronique selon la revendication 1, dans lequel le boîtier microélectronique (110) comprend un dispositif microélectronique (112) attaché à une couche de surépaisseur (120).
